# EUROPÄISCHE PATENTSCHRIFT

(11) **EP 2 135 300 B1**
(45) Veröffentlichungstag und Bekanntmachung des Hinweises auf die Patenterteilung: **08.02.2012**
(21) Anmeldenummer: 08716040.4
(22) Anmeldetag: 26.02.2008
(51) Int. Cl.: H01L 31/068, H01L 31/0224, H01L 31/18

(54) **Verfahren zur Herstellung einer Solarzelle sowie damit hergestellte Solarzelle**
Method for the production of a solar cell and solar cell produced using said method
Procédé de fabrication d'une cellule solaire et cellule solaire ainsi fabriquée

(30) Priorität: 08.03.2007 DE 102007012277
(43) Veröffentlichungstag der Anmeldung: 23.12.2009
(73) Patentinhaber: Gebr. Schmid GmbH, 72250 Freudenstadt (DE)
(72) Erfinder: SCHMID, Christian, 72250 Freudenstadt (DE); HABERMANN, Dirk, 79199 Kirchzarten (DE)
(74) Vertreter: Patentanwälte Ruff, Wilhelm, Beier, Dauster & Partner
(86) Internationale Anmeldenummer: PCT/EP2008/001500
(87) Internationale Veröffentlichungsnummer: WO 2008/107094

(56) Entgegenhaltungen:
- US-A- 4 463 216
- US-A- 6 081 017
- US-A1- 2005 252 544

## Beschreibung

### Anwendungsgebiet und Stand der Technik

Die Erfindung betrifft ein Verfahren zur Herstellung einer Solarzelle mit einer BSF-Schicht (Backsurfacefield), wobei die Solarzelle vorteilhaft aus Silizium bzw. aus einem Silizium-Substrat besteht, sowie eine mit einem derartigen Verfahren hergestellte Solarzelle.

Die Herstellung einer konventionellen Solarzelle beinhaltet eine Folge von Prozessschritten, die im Folgenden in verkürzter Form dargestellt werden. Als Basis dienen meist mono- oder polykristalline p-Si-Wafer, die zur Verbesserung der Absorptionseigenschaften an der Oberfläche über einen Ätzprozess texturiert werden. Dieser Ätzprozess wird bei monokristallinem Silizium mit einem Gemisch aus Natron- oder Kalilauge mit Isopropylalkohol durchgeführt. Polykristallines Silizium wird mit einer Lösung aus Fluss- und Salpetersäure geätzt. Anschließend werden weitere Ätz-Reinigungssequenzen durchgeführt, um die Oberfläche optimal für den folgenden Diffusionsprozess vorzubereiten. Bei diesem Prozess wird ein pn-Übergang im Silizium durch die Diffusion von Phosphor in eine Tiefe von ca. 0,5µm erzeugt. Der pn-Übergang trennt die durch Licht gebildeten Ladungsträger. Zur Erzeugung des pn-Übergangs wird der Wafer auf ca. 800°C - 950°C in einem Ofen in Anwesenheit einer Phosphorquelle erhitzt, meist ein Gasgemisch oder eine wässrige Lösung. Hierbei dringt Phosphor in die Siliziumoberfläche ein. Die mit Phosphor dotierte Schicht ist negativ leitend im Gegensatz zur positiv leitenden Bor-dotierten Basis. Bei diesem Prozess entsteht an der Oberfläche ein Phosphorglas, das in den Folgeschritten durch eine Ätzung mit HF entfernt wird. Anschließend wird auf die Silizium-Oberfläche eine rund 80 nm dicke Schicht, meist bestehend aus SiN:H, zur Reduzierung der Reflexion und zur Passivierung aufgebracht. Dann werden metallische Kontakte auf der Vorderseite (Silber) und Rückseite (Gold oder Silber) aufgebracht. Bei diesem Prozess wird zur Herstellung eines so genannten BSF (Backsurfacefield), vorteilhaft aus Aluminium, ein Teil des aufgebrachten Aluminiums auf der Wafer-Rückseite im anschließenden Feuerungsschritt in das Silizium einlegiert.

Die US 2005/0252544 A1 beschreibt ein Verfahren zum Herstellen einer Solarzelle mit einer BSF-Schicht. Auf der Rückseite einer Solarzelle wird Aluminium als Kontaktschicht aufgebracht zur Herstellung einer BSF-Schicht. Durch anschließendes Erhitzen wird das Aluminium in das Solarzeilen-Substrat einlegiert.

Aus der US 6,081,017 A ist es ebenfalls bekannt, an der Rückseite einer Solarzelle eine Aluminiumschicht als BSF-Schicht anzubringen und durch Erwärmen das Aluminium in das Solarzellen-Substrat einzulegieren. Diese BSF-Schicht aus Aluminium verbleibt dann als strukturierte Elektrode zum elektrischen Anschluss der Solarzelle.

### Aufgabe und Lösung

Der Erfindung liegt die Aufgabe zugrunde, ein eingangs genanntes Verfahren sowie eine damit hergestellte Solarzelle zu schaffen, mit denen Nachteile des Standes der Technik vermieden werden können und insbesondere der Wirkungsgrad einer Solarzelle weiter gesteigert werden kann.

Gelöst wird diese Aufgabe durch ein Verfahren mit den Merkmalen des Anspruchs 1 sowie eine Solarzelle mit den Merkmalen des Anspruchs 14. Vorteilhafte sowie bevorzugte Ausgestaltungen der Erfindung sind Gegenstand der weiteren Ansprüche und werden im Folgenden näher erläutert. Der Wortlaut der Ansprüche wird durch ausdrückliche Bezugnahme zum Inhalt der Beschreibung gemacht. Des weiteren wird der Wortlaut der Prioritätsanmeldung DE 102007012277.4 vom 8. März 2007 derselben Anmelderin durch ausdrückliche Bezugnahme zum Inhalt der vorliegenden Beschreibung gemacht.

Erfindungsgemäß wird auf die Rückseite eines Solarzeilen-Substrats, das insbesondere aus Silizium besteht, eine BSF-Schicht dadurch aufgebracht, dass zuerst Aluminium auf das Substrat aufgebracht wird. Anschließend wird Aluminium oder ein Teil davon in das Substrat einiegiert, wobei die entstehende BSF-Schicht transparent ist bzw. keine Abschattung bewirkt. Der Vorteil dieses Herstellungsverfahrens sowie eines damit erzeugten BSF liegt darin, dass auch zweiseitige bzw. sogenannte bifaciale Solarzellen hergestellt werden können, die also auch von der Rückseite bestrahlt werden können, ohne dass das BSF eine Abschattung bewirkt. Vor allem können so sowohl großflächige als auch kleine bzw. lokale BSF geschaffen werden. Des Weiteren können verschiedene Aufbringungsverfahren für das Aluminium verwendet werden, wie nachfolgend noch dargelegt wird. Schließlich ist ein solches Verfahren relativ günstig und so kann eine im Vergleich zu anderen hocheffizienten Solarzellen günstige Zelle geschaffen werden. Durch die Verwendung von Aluminium anstelle von Bor für das BSF kann ein erheblich günstigerer und besser zu beherrschender Prozess eingesetzt werden, unter anderem auch dadurch, dass die Legierungstemperatur für Aluminium erheblich niedriger liegt als die für Bor, insbesondere bei weniger als 900°C. Dadurch kann beispielsweise auch multikristallines Silizium verwendet werden, welches beim Einlegieren mit Bor aufgrund der hohen Temperaturen von weit über 1000°C nachteilig verändert werden würde.

Bei einer Ausgestaltung der Erfindung kann Aluminium punktartig bzw. in kleinen Bereichen auf das Substrat bzw. eine Rückseite des Substrats aufgebracht werden. So können mehrere BSF punktartig bzw. nach Art von kleinen Bereichen erzeugt werden. Vorteilhaft ist vorgesehen, dass diese Punkte bzw. kleinen Bereiche entlang von Linien liegen, die insbesondere gleichen Abstand aufweisen. Bevorzugt können sie nach Art eines gleichmäßigen Rasters aufgebracht werden, wodurch eine gleichmäßige elektrische Kontaktierung am BSF möglich ist. Auf das BSF bzw. die kleinen Bereiche werden, insbesondere entlang der genannten Linien, anschließend metallische Kontakte aufgebracht, beispielsweise aus Nickel oder Silber oder Kombinationen davon.

In einer etwas anderen Ausgestaltung der Erfindung kann das Aufbringen von Aluminium auf das Substrat und somit das Erzeugen eines BSF bzw. leitfähiger Bereiche für das BSF nach Art der vorbeschriebenen Linien selber erfolgen. Auch hier ist es vorteilhaft, wenn die Linien parallel zueinander sind und gleichen Abstand aufweisen.

In einer nochmals etwas anderen Ausgestaltung der Erfindung kann Aluminium flächig bzw. großflächig auf die Rückseite des Substrats aufgebracht werden, insbesondere dessen gesamte Rückseite bedecken. Hier ist es zwar grundsätzlich möglich, verschiedene Schichtdicken bzw. Schichtdickengradienten vorzusehen. Vorteilhaft jedoch wird eine etwa gleichmäßige dicke Schicht aufgebracht. Auch hier können, wie bei dem vorbeschriebenen linienartig aufgebrachten Aluminium mit Erzeugen eines linienartigen Aluminium-BSF, in einem nachfolgenden Schritt metallische Kontakte aufgebracht werden, insbesondere wiederum linienartige metallische Kontakte.

Für die Aufbringung des Aluminiums auf das Substrat gibt es unterschiedliche Möglichkeiten. Gemäß einer Möglichkeit kann es durch Siebdruckverfahren oder durch ein Ink-Jet-Verfahren aufgebracht werden. Des Weiteren kann es in flüssiger bzw. pastöser Form aufgebracht werden, beispielsweise als aluminiumhaltige Flüssigkeit oder aluminiumhaltiges Gel. Gemäß einer nochmals weiteren Möglichkeit kann Aluminium ähnlich wie sonstige Metallbeschichtungen durch Sputtern, Verdampfen, CVD-Verfahren oder Legieren aufgebracht werden.

Zum Einlegieren des Aluminiums in das Substrat bzw. das Siliziummaterial des Substrats kann ein Erwärmungsprozess vorgesehen sein. Dieser unterscheidet sich vorteilhaft von einer für das vorhergehende Aufbringen des Aluminiums verwendeten oder dabei auftretenden Erwärmung. So kann dieser Prozess besser gesteuert bzw. für seinen Zweck optimiert werden.

Nach dem Einlegieren von Aluminium in das Substrat bzw. das Siliziummaterial wird erfindungsgemäß ein Teil des übrigen Aluminiums entfernt, und zwar wird nur das Aluminium entfernt, welches nicht in das Substrat einlegiert ist bzw. noch reines Aluminium ist und somit eine sozusagen eigene bzw. unterscheidbare Schicht bildet. Dabei kann dieses nichtlegierte Aluminium entweder vollständig entfernt werden oder aber, beispielsweise auch um eine bessere anschließende elektrische Kontaktierung sowie Aufbringung von elektrischen Kontakten zu ermöglichen, nur teilweise entfernt werden bzw. in linienartigen Form bestehen bleiben. Alternativ ist es möglich, sämtliches nicht-legiertes Aluminium zu entfernen. Vorteilhaft wird das Aluminium durch Ätzen entfernt, wie es an sich bekannt ist

In Ausgestaltung des erfindungsgemäßen Verfahrens kann nach dem Entfernen des Aluminiums eine Passivierung zumindest an der Rückseite des Substrats erfolgen. Ebenso wird vorteilhaft eine Anti-Reflex-Beschichtung aufgebracht, zumindest auf die Rückseite des Substrats. Dies ist insbesondere dann von Vorteil, wenn die Solarzelle auch an der Rückseite mit Licht bestrahlt werden soll.

Bei der Herstellung der Solarzelle ist es möglich, nach dem vorbeschriebenen Entfernen des Aluminiums oder teilweisen Entfernens des Aluminiums einen pn-Übergang am Substrat zu erzeugen, indem Phosphor in n-Silizium eindiffundiert wird.

Des Weiteren ist es möglich, dass insbesondere für einen anschließenden Aufbau der elektrischen Kontaktierung an der Rückseite des Substrats, Metall bzw. Aluminium in vorgefertigte Strukturen am Substrat aufgebracht werden. Derartige Strukturen werden insbesondere an einer vorbeschriebenen Anti-Reflex-Beschichtung erzeugt, wobei diese Erzeugung mechanisch oder beispielsweise durch Laserbearbeitung erfolgen kann. In derartig entstehende Gräben kann also das Aluminium, vorteilhaft in vorbeschriebener Linienform, eingebracht werden, insbesondere auf ein darunter liegendes Aluminium-BSF. Dieses zuletzt aufgebrachte Aluminium wird dann nicht entfernt. Vorteilhaft wird darauf ein rückseitiger, möglichst gut leitender elektrischer Kontakt in Linienform aufgebracht, insbesondere als Silberkontakt.

Diese und weitere Merkmale gehen außer aus den Ansprüchen auch aus der Beschreibung und den Zeichnungen hervor, wobei die einzelnen Merkmale jeweils für sich allein oder zu mehreren in Form von Unterkombinationen bei einer Ausführungsform der Erfindung und auf anderen Gebieten verwirklicht sein und vorteilhafte sowie für sich schutzfähige Ausführungen darstellen können, für die hier Schutz beansprucht wird. Die Unterteilung der Anmeldung in einzelne Abschnitte sowie Zwischen-Überschriften beschränken die unter diesen gemachten Aussagen nicht in ihrer Allgemeingültigkeit.

### Kurzbeschreibung der Zeichnungen

Ausführungsbeispiele der Erfindung sind in den Zeichnungen schematisch dargestellt und werden im Folgenden näher erläutert. In den Zeichnungen zeigen:
- Fig. 1: einen Schnitt durch eine Solarzelle, die nach einer ersten Ausgestaltung des erfindungsgemäßen Verfahrens hergestellt worden ist mit einem flächigen Aluminium-Backsurfacefield, wobei das reine Aluminium entfernt worden ist,
- Fig. 2: eine zweite Ausgestaltung einer Solarzelle ähnlich Fig. 1 mit einem linienartigen Aluminium-Backsurfacefield, wobei auch hier das reine Aluminium entfernt worden ist und
- Fig. 3: eine dritte Ausgestaltung einer Solarzelle, ähnlich Fig. 2, wobei das reine Aluminium nicht entfernt worden ist, die nicht zur beanspruchten Erfindung gehört.

### Detaillierte Beschreibung der Ausführungsbeispiele

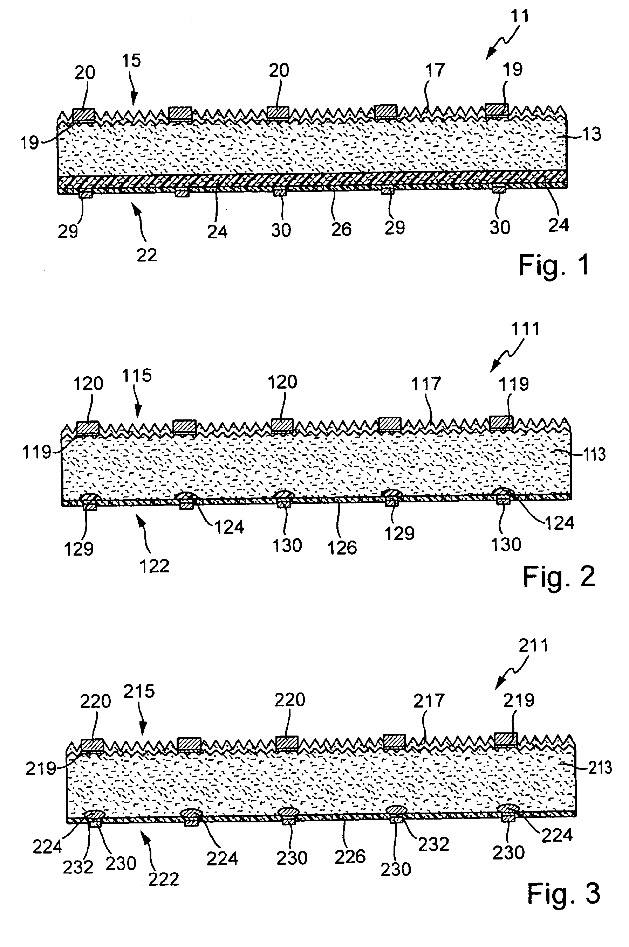

In Fig. 1 ist eine Solarzelle 11 dargestellt, bestehend aus einem Substrat 13 aus p-dotiertem Silizium. Auf die Vorderseite 15 des Substrats 13 ist eine Antireflexions-Schicht 17, beispielsweise bestehend aus SiN:H, aufgebracht, sowie eine nicht dargestellte Passivierung des darunter liegenden Substrats 13 vorgenommen worden. Des Weiteren sind auf der Vorderseite 15 Kontakte in Gräben in der Antireflexions-Schicht 17 eingebracht, die aus einem unteren Nickel-Kontakt 19 und einem darauf aufgebrachten Silber-Kontakt 20 bestehen. Die entsprechenden Gräben in der Antireflexions-Schicht 17 für die Kontakte 19 und 20 können durch Ätzen erzeugt werden, alternativ kann eine mechanische Bearbeitung erfolgen oder eine Laser-Bearbeitung. Die Nickel-Kontakte 19 können durch sogenanntes Elektro-Less-Plating aufgebracht werden, während die Silber-Kontakte 20 in einem LIP-Verfahren aufgebracht werden können. Die Kontakte 19 und 20 sind dabei linienförmig und liegen direkt auf einer darunter liegenden Silizium-Schicht des Substrats 13 auf.

Auf eine Rückseite 22 der Solarzelle 11 wird von unten an das Silizium-Substrat 13 ein flächiges Aluminium-Backsurfacefield bzw. Aluminium-BSF 24 aufgebracht. Das Aluminium kann wie vorbeschrieben über ein Siebdruckverfahren oder anders aufgetragen werden. Vor einem Einlegieren bzw. Einbrennen in das Silizium kann ein Trocknungszwischenschritt stattfinden. Das Einlegieren kann in einem Ofen, durch Bestrahlung mit Licht oder durch Erhitzen erfolgen.

Anschließend wird bei der Solarzelle 11 nach Fig. 1 das oberflächlich aufgebrachte, sozusagen reine Aluminium, das nicht in das Silizium hineinlegiert ist, entfernt, vorteilhaft über einen Ätzschritt. Der große Vorteil liegt hier darin, dass die übrigbleibende AlSi-Legierung im Aluminium-BSF 24 tatsächlich transparent ist und so sozusagen auch eine bifaciale Solarzelle 11 geschaffen werden kann, die also auch bei Lichteinfall an der Rückseite 22 arbeitet. Ein weiterer Vorteil liegt darin, dass durch die Verwendung von Aluminium das Eindotieren von Bor bzw. Bor vermieden werden kann. Aluminium ist nämlich leichter handzuhaben als Bor, unter anderem durch geringere Temperaturen zum Aufbringen und Einlegieren.

Auf das Aluminium-BSF 24 ist eine weitere Antireflexions-Schicht 26 aufgebracht. In diese Beschichtung 26 ist wieder ein Kontakt eingebracht, vorteilhaft ähnlich wie auf der Vorderseite 15 bzw. zuerst ein Nickelkontakt 29 und dann ein Silberkontakt 30 aufgebracht.

In Fig. 2 ist eine alternative Solarzelle 111 dargestellt, hergestellt mit einem alternativen Verfahren. Auf einem Silizium-Substrat 113 ist, ähnlich wie zu-Fig. 1 beschrieben, an einer Vorderseite 115 eine Antireflexions-Schicht 117 aufgebracht. Diese ist mit gitterartigem Muster durchtrennt bzw. bis auf das Substrat 113 geöffnet und es sind zuerst Nickelkontakte 119 und darauf Silberkontakte 120 aufgebracht. So kann ein Nickelkontakt beispielsweise durch chemische Metallisierung aufgebracht werden.

Abweichend von der Darstellung in Fig. 1 ist an einer Rückseite 122 Aluminium lediglich punktuell, also in kleinen Bereichen oder Linien, aufgebracht, und nicht wie in Fig. 1 großflächig. Die grundsätzliche Aufbringung des Aluminiums kann jedoch wie zuvor beschrieben erfolgen. Anschließend wird beispielsweise nach einem Einlegieren wiederum, ähnlich wie zu Fig. 1 beschrieben, überschüssiges bzw. reines Aluminium weggeätzt und es verbleiben die eher kleinen Bereiche des Aluminium-Backsurfacefields 124. Über dem Aluminium-BSF 124 wird in eine rückseitig aufgebrachte Antireflexions-Schicht 126 eine Struktur eingebracht bzw. diese geöffnet, beispielsweise durch Ätzen oder mechanische Bearbeitung. Anschließend wird, wie zuvor beschrieben, zuerst ein Nickelkontakt 129 und dann darauf ein Silberkontakt 130 aufgebracht. Auch bei der Solarzelle 111 gemäß Fig. 2 ist das Aluminium-BSF 124 durchsichtig. Des Weiteren ist es auf eine sehr viel geringere Fläche beschränkt als bei der Solarzelle 11 gemäß Fig. 1.

In Fig. 3, die nicht zur beanspruchten Erfindung gehört, ist schließlich eine weitere Solarzelle 211 dargestellt, welche wiederum etwas anders ausgebildet ist. An einer Vorderseite 215 ist der Aufbau wie zuvor beschrieben mit Antireflexions-Schicht 217, unterem Nickelkontakt 219 und oberem Silberkontakt 220. An einer Rückseite 222 dagegen ist zwar, wie zuvor beschrieben, Aluminium für ein linienartiges oder punktartiges Aluminium-Backsurfacefield 224 aufgebracht und in das Silizium hineinlegiert worden. Allerdings ist das reine Aluminium nicht, wie zuvor beschrieben, entfernt worden, sondern bildet nun einen Ersatz für die unteren Nickelkontakte gem. Fig. 1 oder 2, und zwar als Aluminiumkontakt 232. Darauf ist ein unterer Silberkontakt 230 aufgebracht. Ein Unterschied der Solarzelle 211 gemäß Fig. 3 zu der Solarzelle 111 gemäß Fig. 2 liegt also darin, dass nach dem Einlegieren des Aluminiums zur Erzeugung des Aluminium-BSF das restliche, reine Aluminium nicht entfernt wird, sondern einen Ersatz für den unteren Nickelkontakt bildet. Damit ist auch diese Solarzelle 211, ähnlich wie die Solarzelle 11 gemäß Fig. 1, relativ leicht herzustellen.

Vor dem Aufbringen der verschiedenen, in den Fig. dargestellten Schichten, beispielsweise dem Aufbringen von Aluminium für das Aluminium-BSF, können Vorbehandlungen des Substrats stattfinden. So kann ein Silizium-Wafer beispielsweise texturiert werden und/oder geätzt werden, um die Oberfläche zu optimieren und Sägeschäden zu beseitigen. Des Weiteren erfolgt eine Phosphor-Dotierung zur Emitterbildung. Ebenso kann ein weiterer Verfahrensschritt zur Behandlung der Solarzellen erfolgen, beispielsweise ein Tempern.

Es ist bei den dargestellten erfindungsgemäßen Solarzellen möglich, multikristallines Siliziummaterial zu verwenden. Dies war früher nicht möglich, da früher beim Einlegieren mit Bor höhere Temperaturen notwendig waren, welche das multikristalline Silizium zerstört hätten. Zum Legieren von Aluminium kann die Temperatur deutlich unter 900°C gehalten werden. Somit kann also im Rahmen der Erfindung auch multikristallines Siliziummaterial für das Substrat verwendet werden. Des Weiteren ist an den freiliegenden Silberkontakten ein Löten als elektrischer Anschluss möglich.

## Patentansprüche

1. Verfahren zum Herstellen einer Solarzelle (11, 111, 211) mit einer BSF-Schicht, wobei auf die Rückseite (22, 122, 222) eines Solarzellen-Substrats (13, 113, 213), insbesondere eines SiliziumSubstrats, eine BSF-Schicht (24, 124, 224) aufgebracht wird durch Aufbringen von Aluminium auf das Substrat und anschließendes Einlegieren in das Substrat (13, 113, 213), wobei die BSF-Schicht (24, 124, 224) für Licht transparent ist, **dadurch gekennzeichnet, dass** nach dem Einlegieren in das Substrat (13, 113) ausschließlich das nicht in das Substrat einlegiertes Aluminium entfernt wird.

2. Verfahren nach Anspruch 1, **dadurch gekennzeichnet, dass** das Aufbringen von Aluminium auf das Substrat (113, 213) punktartig bzw. in kleinen Bereichen erfolgt, wobei vorzugsweise eine lokale Herstellung von mehreren BSF's (124, 224) in Punktform bzw. nach Art von kleinen Bereichen erfolgt, wobei die Punkte bzw. kleinen Bereiche entlang von geradlinigen, insbesondere mit gleichem Abstand versehenen, Linien liegen, auf die anschließend linienartige metallische Kontakte (129, 130, 232, 229) aufgebracht werden.

3. Verfahren nach Anspruch 1, **dadurch gekennzeichnet, dass** das Aufbringen von Aluminium auf das Substrat (113, 213) linienartig erfolgt.

4. Verfahren nach Anspruch 1, **dadurch gekennzeichnet, dass** Aluminium flächig auf das Substrat (13) aufgebracht wird für ein flächiges BSF (24), wobei vorzugsweise die im wesentlichen gesamte Fläche einer Seite des Substrats bedeckt wird.

5. Verfahren nach einem der vorhergehenden Ansprüche, **dadurch gekennzeichnet, dass** das Aluminium durch Siebdruckverfahren auf das Substrat (13, 113, 213) aufgebracht wird.

6. Verfahren nach einem der Ansprüche 1 bis 4, **dadurch gekennzeichnet, dass** das Aluminium flüssig bzw. pastös aufgebracht wird, vorzugsweise in Form einer aluminiumhaltigen Flüssigkeit oder eines aluminiumhaltigen Gels.

7. Verfahren nach einem der Ansprüche 1 bis 4, **dadurch gekennzeichnet, dass** das Aluminium durch Sputtern, Verdampfen, CVD-Verfahren oder Legieren aufgebracht wird.

8. Verfahren nach einem der vorhergehenden Ansprüche, **dadurch gekennzeichnet, dass** das Einlegieren des Aluminiums in das Substrat (13, 113, 213) bzw. das Siliziummaterial des Substrats durch von dem Aufbringen des Aluminiums separate Erwärmung erfolgt.

9. Verfahren nach Anspruch 1, **dadurch gekennzeichnet, dass** das sämtliche nicht mit dem Siliziummaterial legierte bzw. nicht hineinlegierte Aluminium entfernt wird.

10. Verfahren nach Anspruch 1 oder 9, **dadurch gekennzeichnet, dass** das Aluminium durch Ätzen entfernt wird.

11. Verfahren nach einem der Ansprüche 1 oder 9 oder 10, **dadurch gekennzeichnet, dass** nach dem Entfernen des Aluminiums eine Passivierung erfolgt und dann das Aufbringen einer Anti-Reflexions-Beschichtung (26, 126, 226) auf der Rückseite (22, 122, 222) des Substrats (13, 113, 213).

12. Verfahren nach einem der Ansprüche 1 oder 9 bis 11, **dadurch gekennzeichnet, dass** nach dem Entfernen des Aluminiums ein pn-Übergang durch die Diffusion von Phosphor in n-Silizium des Substrats (13, 113, 213) erzeugt wird.

13. Verfahren nach einem der vorhergehenden Ansprüche, **dadurch gekennzeichnet, dass** das Aluminium in vorgefertigte Strukturen am Substrat (13, 113, 213), insbesondere in Strukturen durch eine Anti-Reflexions-Beschichtung (26, 126, 226) bis hinunter zum Substrat, hinein aufgebracht wird, insbesondere durch SiebdruckVerfahren, ohne anschließende Entfernung des Aluminiums.

14. Solarzelle (11, 111, 211), **dadurch gekennzeichnet, dass** sie aus einem Substrat (13, 113, 213) hergestellt ist, das mit einem Verfahren nach einem der vorhergehenden Ansprüche behandelt worden ist.

## Claims

1. Method for the manufacture of a solar cell (11, 111, 211) with a BSF coating, wherein to the back surface (22, 122, 222) of a solar cell substrate (13, 113, 213), in particular a silicon substrate, is applied a BSF coating (24, 124, 224) by application of aluminium to the substrate and subsequent alloying into the substrate (13, 113, 213), the BSF coating (24, 124, 224) being transparent for light, **characterized in that** following the alloying step into the substrate (13, 113) solely aluminium not alloyed into the substrate is removed.

2. Method according to claim 1, **characterized in that** aluminium is applied to the substrate (113, 213) in punctiform manner or in small areas, wherein preferably a local production of several BSF's (124, 224) in punctiform manner or in small areas is provided, these points or small areas being located along straight lines, which in particular have the same spacing, and to which subsequently linear, metallic contacts (129, 130, 232, 229) are applied.

3. Method according to claim 1, **characterized in that** aluminium is applied linearly to the substrate (113, 213).

4. Method according to claim 1, **characterized in that** aluminium is applied in a spread out manner onto the substrate (13) for a spread out BSF (24), wherein preferably essentially the entire area of one side of the substrate is covered.

5. Method according to any of the preceding claims, **characterized in that** aluminium is applied to the substrate (13, 113, 213) by a screen printing process.

6. Method according to any of the claims 1 to 4, **characterized in that** aluminium is applied in liquid or pasty from, preferably in the form of aluminium-containing liquid or aluminium-containing gel.

7. Method according to any of the claims 1 to 4, **characterized in that** aluminium is applied by sputtering, vaporizing, CVD process or alloying.

8. Method according to any of the preceding claims, **characterized in that** the alloying of the aluminium into the substrate (13, 113, 213) or the substrate silicon material takes place through heating which is separate from aluminium application.

9. Method according to claim 1, **characterized in that** all aluminium not alloyed in or not alloyed with the silicon material is removed.

10. Method according to claim 1 or 9, **characterized in that** the aluminium is removed by etching.

11. Method according to claim 1 or 9 or 10, **characterized in that** following aluminium removal a passivation takes place and then an antireflection coating (26, 126, 226) is applied to the back surface (22, 122, 222) of substrate (13, 113, 213).

12. Method according to claim 1 or 9 to 11, **characterized in that** following aluminium removal a p-n junction is produced by the diffusion of phosphorus into the n-silicon of the substrate (13, 113, 213).

13. Method according to any of the preceding claims, **characterized in that** the aluminium is applied on the substrate (13, 113, 213) in prefabricated structures, in particular in structures through an antireflection coating (26, 126, 226) down to the substrate, in particular by a screen printing process without subsequent aluminium removal.

14. Solar cell (11, 111, 211), **characterized in that** it is made from a substrate (13, 113, 213) which is treated with a method according to any of the preceding claims.

## Revendications

1. Procédé de fabrication d'une cellule solaire (11, 111, 211) dotée d'une couche BSF, dans lequel une couche BSF (24, 124, 224) est appliquée sur le côté arrière (22, 122, 222) d'un substrat (13, 113, 213) de cellule solaire, en particulier d'un substrat de silicium, par application d'aluminium sur le substrat et ensuite incorporation de l'aluminium dans le substrat (13, 113, 213) par alliage, la couche BSF (24, 124, 224) étant transparente vis-à-vis de la lumière,
**caractérisé en ce que**
après l'incorporation dans le substrat (13, 113) par alliage, seul l'aluminium qui ne s'est pas allié avec le substrat est enlevé.

2. Procédé selon la revendication 1, **caractérisé en ce que** l'application de l'aluminium sur le substrat (113, 213) s'effectue par points ou dans de petites zones, la formation locale de plusieurs BSF (124, 224) s'effectuant sous la forme de points ou de petites zones, les points ou les petites zones étant situés le long de lignes rectilignes, en particulier équidistantes, sur lesquelles des contacts métalliques linéaires (129, 130, 232, 229) sont ensuite appliqués.

3. Procédé selon la revendication 1, **caractérisé en ce que** l'application d'aluminium sur le substrat (113, 213) s'effectue en lignes.

4. Procédé selon la revendication 1, **caractérisé en ce que** pour un BSF de surface (24), l'aluminium est appliqué sur une surface du substrat (13), de préférence la totalité de la surface d'un côté du substrat étant revêtue.

5. Procédé selon l'une des revendications précédentes, **caractérisé en ce que** l'aluminium est appliqué sur le substrat (13, 113, 213) par une opération de sérigraphie.

6. Procédé selon l'une des revendications 1 à 4, **caractérisé en ce que** l'aluminium est appliqué à l'état liquide ou pâteux, de préférence sous la forme d'un liquide contenant de l'aluminium ou d'un gel contenant de l'aluminium.

7. Procédé selon l'une des revendications 1 à 4, **caractérisé en ce que** l'aluminium est appliqué par pulvérisation, vaporisation, opération CVD ou alliage.

8. Procédé selon l'une des revendications précédentes, **caractérisé en ce que** l'incorporation d'aluminium dans le substrat (13, 113, 213) ou dans le matériau de silicium du substrat par alliage s'effectue par un chauffage distinct de l'application de l'aluminium.

9. Procédé selon la revendication 1, **caractérisé en ce que** la totalité de l'aluminium non allié avec le matériau de silicium ou non incorporé par alliage est enlevée.

10. Procédé selon la revendication 1 ou 9, **caractérisé en ce que** l'aluminium est enlevé par gravure chimique.

11. Procédé selon l'une des revendications 1 ou 9 ou 10, **caractérisé en ce qu'**après l'enlèvement de l'aluminium a lieu une passivation suivie par l'application d'un revêtement anti-réfléchissant (26, 126, 226) sur le côté arrière (22, 122, 222) du substrat (13, 113, 213).

12. Procédé selon l'une des revendications 1 ou 9 à 11, **caractérisé en ce qu'**après l'enlèvement de l'aluminium, une jonction p-n est formée par diffusion de phosphore dans le silicium n du substrat (13, 113, 213).

13. Procédé selon l'une des revendications précédentes, **caractérisé en ce que** l'aluminium est appliqué sur le substrat (13, 113, 213) en structures préfabriquées, en particulier en structures à travers un revêtement anti-réfléchissant (26, 126, 226) jusqu'au substrat, en particulier par une opération de sérigraphie qui n'est pas suivie par l'enlèvement de l'aluminium.

14. Cellule solaire (11, 111, 211), **caractérisée en ce qu'**elle est réalisée à partir d'un substrat (13, 113, 213) qui a été traité à l'aide du procédé selon l'une des revendications précédentes.
